(19) Europäisches Patentamt / European Patent Office / Office européen des brevets

(11) **EP 1 459 886 B1**

(12) **EUROPEAN PATENT SPECIFICATION**

(45) Date of publication and mention
of the grant of the patent:
**26.10.2016 Bulletin 2016/43**

(21) Application number: **02786171.5**

(22) Date of filing: **20.12.2002**

(51) Int Cl.:
*G03F 7/09* (2006.01)        *B32B 27/36* (2006.01)

(86) International application number:
**PCT/JP2002/013366**

(87) International publication number:
**WO 2003/057484 (17.07.2003 Gazette 2003/29)**

(54) **LAMINATED FILM**

LAMINIERTE FOLIE

FEUILLE STRATIFIÉE

(84) Designated Contracting States:
**DE FR GB**

(30) Priority: **28.12.2001   JP 2001399703**
**28.12.2001   JP 2001399704**
**24.09.2002   JP 2002276957**

(43) Date of publication of application:
**22.09.2004   Bulletin 2004/39**

(73) Proprietor: **Teijin Dupont Films Japan Limited**
**Tokyo 100-0011 (JP)**

(72) Inventors:
• **OKUYAMA, Shunsuke**
**Teijin DuPont Films Japan Ltd.**
**Sagamihara-shi,**
**Kanagawa 229-1105 (JP)**

• **TAKEUCHI, Hikaru**
**Teijin DuPont Films Japan Limited**
**Sagamihara-shi, Kanagawa 229-1105 (JP)**

(74) Representative: **Cockerton, Bruce Roger et al**
**Carpmaels & Ransford LLP**
**One Southampton Row**
**London WC1B 5HA (GB)**

(56) References cited:
| | |
|---|---|
| EP-A2- 0 823 660 | EP-A2- 0 823 660 |
| EP-A2- 0 905 564 | WO-A-01/49509 |
| JP-A- 6 161 096 | JP-A- 11 240 110 |
| JP-A- 11 349 792 | JP-A- 2000 275 860 |
| JP-A- 2002 062 661 | JP-A- 2002 278 074 |
| US-A- 5 981 690 | |

## Description

Technical Field

The present invention relates to a laminated film, more particularly, a laminated film suitable for a dry film photoresist.

Background Technology

A printed circuit board is one of the main parts used in the field of electronic industry. The printed circuit board is produced by forming a circuit on a substrate using a dry film photoresist (hereinafter occasionally abbreviated as "DFR").

Conventional ordinary DFR has a three-layer structure containing a photoresist layer composed of a photosetting resin, having a thickness of 15 to 50 $\mu$m and sandwiched between a base film composed of a biaxially drawn polyester film having a thickness of 10 to 25 $\mu$m and a protecting film composed of a polyolefin film having a thickness of 30 to 40 $\mu$m. The DFR is traded in the form of a roll having a width of 1 m or over and a film length of 120 to 150 m.

In the production of a printed circuit board, a protecting film is peeled from the photoresist layer and a copper-clad substrate is thermally bonded to the photoresist layer by a laminater. Thereafter, a glass plate having a printed circuit pattern is closely contacted with the base film, the photoresist layer is exposed with light by applying light from the side of the glass plate, the base film is peeled off and the dry photoresist layer is developed. Ultraviolet rays having a wavelength of 365 nm or therearound (hereinafter occasionally called as "UV") are used for the light exposure. Accordingly, a biaxially drawn polyester film having high transparency and excellent ultraviolet transmittance is used as the base film. The protecting film protects the photoresist layer and prevents the adhesion of the photoresist layer to the back surface of the base film in the case of winding the DFR in the form of a roll. Accordingly, a polyolefin film is used as the protecting film.

DFR rolls having a roll width of 1.6 m or over are being used according to the recent progress to increase the width of DFR. It is necessary to use a base film having a thickness of from 10 to 25 $\mu$m for stably producing such broad DFR. The total thickness of the base film and the protecting film is usually about 50 $\mu$m and is thinner the better for reducing the roll size of the DFR.

DFR is slit according to the specification of the copper-clad substrate in a state laminated with the protecting film in the production of a printed circuit board. The slit protecting film and base film cannot be reused and are disposed as industrial wastes.

To solve the problem, the development of a film free from conventional protecting film on the photoresist layer has been investigated. The process to peel the protecting film can be eliminated and the reduction of the amount of industrial wastes can be achieved when the protecting film is absent.

A coverless film has been proposed as such film. The coverless film has a photoresist layer on one surface of a transparent base film and a release layer composed of a polyolefin having releasability to the photoresist layer and formed on the other surface of the base film. A film for a dry film photoresist to be wound in the form of a roll and protect the photoresist layer with the release layer at the back of the base film is called as a dry film photoresist coverless film.

It is necessary to add fine particles to a polyester film to impart the film with handleability. However, the addition of fine particles forms voids in the case of orienting the polymer of the film and lowers the transparency of the film to fail in keeping the high ultraviolet transmission at 365 nm wavelength or thereabout. In this case, high resolution of a pattern formed by exposure is unattainable resulting in the failure in getting a fine circuit pattern.

EP 0905564 A2 concerns a dry film photoresist construction for winding on itself comprising a flexible support layer having top and bottom surfaces suitable for winding into a roll, a photoresist composition adhered to one of said surfaces of said flexible support layer, and a release coating adhered to the opposite side of said layer, said photoresist composition more adherent to said support layer than to said release coating, wherein the support layer is preferably a polyester material.

Disclosure of the Invention

The object of the present invention is to provide a laminated film suitable for a dry film photoresist coverless film having high transparency and ultraviolet-transmittance and exhibiting high resolution and good slipperiness and handleability.

Another object of the present invention is to provide a dry film photoresist coverless film. The application of a protecting film on a photoresist layer is not necessary in this dry film photoresist coverless film.

More specifically, the present invention relates to

　　　Item 1: A laminated film for a dry film photoresist coverless film having a light transmittance of 80% or above at 365 nm wavelength and comprising a biaxially drawn polyester film and a release layer formed on one surface of the biaxially drawn polyester film, wherein the release layer has a releasability to a photoresist layer composed of a photosetting resin, wherein the polyester comprised in the biaxially drawn polyester film is formed by a polycondensation reaction using a polycondensation catalyst, wherein the polycondensation catalyst is a germanium compound, wherein the amount of polycondensation metal catalyst residue in the polyester is less than 150 ppm, and wherein the polyester contains 0.01 to 0.1 wt% of porous silica particles having a pore volume of 0.5 to 2.0 ml/g and an average particle diameter of 0.1 to 5 $\mu$m.

Item 2: A laminated film described in the Item 1 wherein said porous silica particle is an aggregate of primary particles having an average particle diameter of 0.01 to 0.1 $\mu$m.

Item 3: A laminated film described in the Item 2 wherein the number of coarse aggregated particles of the porous silica particles having a size of 50 $\mu$m or larger is 10 or less per 1 $m^2$ of the film.

Item 4: A laminated film described in the Item 1 wherein the content of antimony element is 15 mmol% or below based on the total dicarboxylic acid component of the polyester.

Item 5: A laminated film described in the Item 1 wherein the polyester has an intrinsic viscosity of 0.52 to 1.50 dl/g.

Item 6: A laminated film described in the Item 1 wherein the release layer contains at least one kind of material selected from silicone resin, fluororesin, olefin resin, wax, polyvinyl carbamate and chromium complex.

Item 7: A laminated film described in the Item 1 wherein the contact angle of the biaxially drawn polyester film surface Y with water and the contact angle of the release layer surface R with water satisfy the following formulas (2), (4) and (5) at the same time.

$$20° \leq \theta Y \leq 90° \qquad (2)$$

$$60° \leq \theta R \leq 150° \qquad (4)$$

$$10° \leq \theta R - \theta Y \leq 130° \qquad (5)$$

(in the formulas (2), (4) and (5), $\theta Y$ is the contact angle of the polyester film surface with water and $\theta R$ is the contact angle of the release layer surface with water.)

Item 8: A laminated film described in the Item 1 wherein the center line average height (Ra) of at least one of the film surfaces is 0.005 $\mu$m or over.

Item 9: A laminated film described in the Item 1 wherein the film has a thickness of 2 to 200 $\mu$m

Item 10: A laminated film described in the Item 1 wherein the film has a haze value of 5% or less, and

Item 11: A dry film photoresist coverless film having a photoresist layer on at least one surface of a laminated film described in the Item 1.

The present invention is explained in more detail as follows.

[Biaxially Drawn Polyester Film]

(Polyester)

The polyester film is a film composed of a polyester. The polyester is preferably a polyethylene terephthalate. The polymer may be a homopolymer or a copolymer. Homopolymer of a polyethylene terephthalate especially has high mechanical strength and high light transmittance between visible light of short wavelength side and near ultraviolet ray and, accordingly, is especially suitable for DFR.

When the polyester is a copolymer of a polyethylene terephthalate, the copolymerized component of the copolymer may be a dicarboxylic acid component, a diol component or both of the dicarboxylic acid component and diol component.

Examples of the dicarboxylic acid component are aromatic dicarboxylic acids such as isophthalic acid and phthalic acid, aliphatic dicarboxylic acids such as adipic acid, azelaic acid, sebacic acid and decanedicarboxylic acid and alicyclic dicarboxylic acids such as cyclohexanedicarboxylic acid. Isophthalic acid is preferable among the examples for getting high transparency and tear strength.

Examples of the diol component are aliphatic diols such as 1,4-butanediol, 1,5-hexanediol and diethylene glycol, alicyclic diols such as 1,4-cyclohexanedimethanol and aromatic diols such as bisphenol A.

A single kind or plural kinds of copolymerizing components can be used in the polyester.

(Melting Point of Polyester)

In the case of using a copolymer, the copolymer has a melting point of from 245°C to 258°C (the melting point of homopolymer). A copolymer having a melting point of lower than 245°C gives a film having lowered heat-resistance, developing high heat-shrinkage and exhibiting poor flatness.

The melting point of a polyester is defined as the melting peak measured by using DuPont Instruments 910 DSC at a heating rate of 20°C/min. The quantity of the specimen is 20 mg.

(Intrinsic Viscosity of Polyester)

The intrinsic viscosity of the polyester (measured in o-chlorophenol at 35°C) is preferably between 0.52 and 1.50, more preferably between 0.57 and 1.00 and especially preferably between 0.60 and 0.80. A polyester having an intrinsic viscosity of smaller than 0.52 forms a film having unfavorably low tear strength, and a polyester having an intrinsic viscosity exceeding 1.50 is also unfavorable because high productivity cannot be attained in the production of the polymer and the manufacture of the film.

(Method for Production of Polyester)

The polyester is produced by a polycondensation reaction. For example, the polyester can be produced by the following method.

When the polyester is a homopolymer of polyethylene terephthalate, a reaction product obtained by the esterification reaction of terephthalic acid with ethylene glycol is subjected to a polycondensation reaction until the polymerization degree reaches a target level, or a reaction product obtained by the transesterification reaction of dimethyl terephthalate with ethylene glycol is subjected to a polycondensation reaction until the polymerization degree reaches a target level.

When the polyester is a copolymer of polyethylene terephthalate, a reaction product obtained by the esterification reaction of terephthalic acid, ethylene glycol and a copolymerizing component is subjected to a polycondensation reaction until the polymerization degree reaches a target level, or a reaction product obtained by the transesterification reaction of dimethyl terephthalate, ethylene glycol and a copolymerizing component is subjected to a polycondensation reaction until the polymerization degree reaches a target level.

The polyester obtained by the above-mentioned polycondensation reaction in molten state may be further polymerized in solid phase to obtain a polymer having higher polymerization degree.

(Polycondensation Catalyst for Polyester)

A germanium compound is used as the polycondensation catalyst in the polycondensation reaction of a polyester.

Germanium oxide can be used as the germanium compound. The germanium oxide may be used in the form of amorphous germanium oxide or fine crystalline germanium oxide. These compounds may be used in the form of a solution dissolved in glycol or water in the presence of an alkali metal, an alkaline earth metal or their compounds.

The amount of the polycondensation metal catalyst residue remaining in the polyester is less than 150 ppm, preferably less than 120 ppm, more preferably less than 100 ppm in terms of the metallic element. When the amount of polycondensation metal catalyst residue in the polyester is 150 ppm or over, it is difficult to get a transmittance of 80% or over for the ultraviolet rays of 365 nm wavelength. The use of an antimony-based catalyst is inhibited in the polymerization of a polyester for decreasing the amount of the polycondensation metal catalyst residue in the polyester to a level lower than 150 ppm. The polyester produced without using an antimony-based catalyst is preferable also from the viewpoint of the recycling of the polyester.

The use of a smaller amount of antimony compounds in the polyester is preferable. The antimony element in the polyester is preferably 15 mmol% or below, more preferably 10 mmol% or below and especially preferably 5 mmol% or below based on the total dicarboxylic acid component. The polyester polymerized without using an antimony-based catalyst does not contain more than 10 mmol% antimony element, gives a film for DFR having high resolution and is producible at a low cost. The effect becomes more significant by carrying out the polymerization of the polyester using a germanium compound.

(Additives for Polyester)

The polyester may be incorporated with additives. Examples of additives are antioxidants, heat-stabilizers, viscosity modifiers, plasticizers, color improvers, lubricants and nucleation agents.

(Method for the Film-Forming of a Biaxially Drawn Polyester Film)

The biaxially drawn polyester film can be produced principally by melting and forming a film of a polyester composition containing porous silica particles to be mentioned later, biaxially drawing the film and subjecting to heat-treatment. The method and condition for each step can be selected from conventional methods and conditions.

For example, the polyester film can be produced by melting a polyester, extruding in the form of a sheet through a slit die, cooling and solidifying on a casting drum to form an undrawn sheet, drawing the undrawn sheet in longitudinal and lateral directions at a drawing temperature of 70 to 120°C at draw ratios of 3 to 5 and heat-treating the drawn product at 200 to 250°C.

[Porous Silica Particles]

(Porous Silica Particles)

The polyester constituting the polyester film contains porous silica particles having a pore volume of 0.5 to 2.0 ml/g and an average particle diameter of 0.1 to 5 $\mu$m in an amount of preferably 0.01 to 0.1% by weight. The porous silica particle is an aggregate of primary particles having an average particle diameter of preferably 0.01 to 0.1 $\mu$m The number of coarse aggregate particles having a particle diameter of 50 $\mu$m or over is preferably 10 or less per 1 $m^2$ of the film.

The use of spherical silica particle or amorphous silica particle in place of the porous silica particle is undesirable because it sometimes forms voids by the drawing of the polyester film for the orientation of the molecule and fails in getting a sufficient transparency for the use of the film as a dry
film photoresist.

(Average Particle Diameter of Primary Particles of Porous Silica Particle)

The porous silica particle is an aggregate of primary particles. The average particle diameter of the primary particles is preferably 0.01 to 0.1 $\mu$m. Primary particles having an average particle diameter of smaller than 0.01 $\mu$m are undesirable because the ultrafine particles are generated by the disintegration of the primary particle in a slurrying stage and they tend to form a coarse aggregate. On the contrary, primary particles having an average particle diameter of larger than 0.1 $\mu$m is also undesirable because they have less porosity. It causes less affinity of the particle to the polyester, and tends to form voids which sometimes gives low transparency.

(Pore Volume of Porous Silica Particle)

The pore volume of the porous silica particle is 0.5 to 2.0 ml/g, preferably 0.6 to 1.8 ml/g. Particle having a pore volume of smaller than 0.5 ml/g is undesirable owing to the loss of the porosity of the particle, which causes the void-forming tendency and sometimes gives low transparency. When the pore volume exceeds 2.0 ml/g, the particles are easy to be disintegrated and agglomerated. This makes it difficult to control the particle diameter.

(Average Particle Diameter of Aggregate Particle of Porous Silica Particle)

The average particle diameter of porous silica particles, namely, the average particle diameter of the secondary particles as the aggregate of primary porous silica particles is 0.1 to 5 $\mu$m, preferably 0.3 to 3 $\mu$m Porous silica particle having an average particle diameter smaller than 0.1 $\mu$m is undesirable because of the insufficient slipperiness of the film. The average particle diameter exceeding 5 $\mu$m is also undesirable owing to the roughening of the film surface resulting in the poor contact to a glass plate having a printed circuit and the formation of a part having low resolution.

(Content of Porous Silica Particle)

The porous silica particle is added to the polyester in an amount of 0.01 to 0.1% by weight, preferably 0.02 to 0.06% by weight. A polyester having a silica particle content of smaller than 0.01% by weight is undesirable owing to the insufficient slipperiness of the film to frequently cause the breakage and scratch in the film-forming process and make the film forming procedure difficult. On the contrary, a polyester having a silica particle content exceeding 0.1% by weight is undesirable because of the lowering of transparency.

(Coarse Aggregate Particle)

The number of coarse aggregate particles having a particle diameter of 50 $\mu$m or over in the porous silica particles in the film is preferably not more than 10, more preferably not more than 5, especially preferably not more than 3 per 1 m$^2$ of the film. When the number of coarse aggregate particles having a size of 50 $\mu$m or over is more than 10 per 1 m$^2$ of the film, non-uniform protrusions are formed on the film surface to give poor contact to the glass plate having a printed circuit and generate a part failing in getting high resolution. The number of coarse aggregate particles having a particle size of 100 $\mu$m or over is preferably not more than 2 per 1 m$^2$ of the film.

A film containing not more than 10 coarse aggregate particles per 1 m$^2$ of the film can be produced preferably by filtering the polyester composition to be manufactured into the film. The filter is a nonwoven fiber filter made of fine stainless steel fiber having a diameter of 15 $\mu$m or smaller and an average mesh opening of preferably 10 to 30 $\mu$m, more preferably 15 to 25 $\mu$m. A filter having a mesh opening larger than 30 $\mu$m cannot attain the effect to decrease the coarse particles in the molten polymer, and a filter having a mesh opening smaller than 10 $\mu$m causes high filtration pressure and large pressure increase and is difficult to use for practical industrial use. When the fiber diameter exceeds 15 $\mu$m, coarse particles cannot be caught at an average mesh opening of 10 to 30 $\mu$m.

When a filter composed of other mesh structure or sintered metal is used in place of the nonwoven fiber filter composed of stainless steel fiber, it is difficult to remove the coarse aggregate particles of the porous silica particles even by using the filter having an average mesh opening comparable to or smaller than that of the nonwoven fabric-type filter. The reason is supposed that the fine stainless steel fiber constituting the nonwoven fiber filter has the effect to disintegrate and disperse the coarse aggregate particle in addition to the effect to capture the coarse porous silica particles.

(Method for the Addition of Porous Silica Particle)

The porous silica particles are added during the reaction for producing the polyester, namely, at an arbitrary stage during the transesterification reaction or the polycondensation reaction in the case of transesterification method or at an arbitrary stage to the reaction system in the case of direct polymerization method preferably as a slurry dispersed in glycol. Especially preferably, the porous silica particles are added to the reaction system at the initial stage of the polycondensation reaction, for example, before the intrinsic viscosity reaches about 0.3.

[Release Layer]

(Release Layer)

A release layer is formed on one surface of the polyester film. The release layer has releasability to a photoresist layer composed of a photosetting resin. The release layer preferably has the following characteristics.

(1) The peeling force (180°, low-speed peeling) is within the range of 0,4-40g/cm.
(2) There is little generation of electrostatic charge in peeling to prevent the deposition of dust, foreign matter, etc.
(3) The layer has heat-resistance and solvent resistance durable to the drying treatment after the application of the photoresist layer. The heat-resistance is preferably the level to endure e.g. the drying treatment at 120°C for 1 minute.
(4) The layer preferably has the transmittance to transmit the ultraviolet rays (UV light) to a level comparable to the base film.
(5) The layer preferably has an air escape property. For example, the surface of the release layer has an unevenness of 0.1 to 10 $\mu$m or thereabout.

(Release Agent)

The release layer is composed of a release agent. Examples of the release agent are silicone resins, fluororesins, olefin resins, waxes, polyvinyl carbamates and chromium complexes.

The release layer may be compounded with various conventional additives to an extent not to hinder the object of the present invention. Examples of the additive are ultraviolet absorbers, antistatic agents, pigments and defoaming agents.

The release layer can be formed for example by an extrusion lamination described in the Japanese Patent No.2,882,953, coating the liquid containing the release agent in the polyester film manufacture process, or coating a solution containing the release agent to a biaxially oriented polyester film followed by heating and drying.

The release layer may be formed at an arbitrary stage of the film-making process, however, it is preferably performed immediately after the drum casting or immediately after the longitudinal drawing after the drum casting.

In the case of forming a release layer by coating a solution containing a release agent to a biaxially oriented polyester film, the conditions for the drying are preferably at 70 to 150°C for 5 to 120 seconds, more preferably at 80 to 120°C for 10 to 60 seconds.

The solution can be coated for example by bar coating method, reverse roll coating method, doctor blade method or gravure roll coating method.

(Thickness of the Release Layer)

The thickness of the release layer is preferably 0.01 to 0.5 $\mu$m, more preferably 0.02 to 0.2 $\mu$m. A sufficient release force is unattainable at the thickness of thinner than 0.01 $\mu$m and the haze value of the film becomes too high when the thickness of the release layer exceeds 0.5 $\mu$m.

[Film Properties]

(Water Contact Angle of Laminated Film Surface)

The water contact angles of the laminated film of the present invention on the film surface of the other side of the release layer (surface Y) and the surface of the release layer (surface R) preferably satisfy the following formulas (2), (4) and (5).

$$20° \leqq \theta Y \leqq 90° \qquad (2)$$

$$60° \leqq \theta R \leqq 150° \qquad (4)$$

$$10° \leqq \theta R - \theta Y \leqq 130° \qquad (5)$$

(in the formulas (2), (4) and (5), $\theta Y$ is the water contact angle of the laminated polyester film on the film surface of the other side of the release layer and $\theta R$ is the water contact angle of the release layer surface.)

Both the surface Y of the laminated polyester film and the surface R of the release layer do not come into close contact with the photoresist during the lamination process of the photoresist layer to the laminated polyester film and then good laminated product is hardly obtained unless the laminated film satisfies the above formulas (2), (4) and (5) at the same time. Further, the surface R of the release layer of the laminated polyester film tends to stick to the surface of the photoresist layer during the winding of the laminate having the photoresist layer laminated on the surface Y of the laminated polyester film to cause the difficulty in the unwinding of the roll. The lower limit of $\theta R$ is more preferably 70° , and $\theta R$- $\theta Y$ is more preferably 15 to 130° , especially preferably 20 to 130° .

In the present invention, the polyester film for the laminated film is preferably surface-treated for satisfying the formulas (2), (4) and (5) at the same time. The surface-treatment can be carried out for example by the corona treatment of a surface of the polyester film at the surface Y of the other side of the release layer or generating a layer satisfying the formula (2) to the surface.

(Roughness of Laminated Film)

The center-line average height (Ra) of at least one surface of the laminated film of the present invention is preferably 0.005 $\mu$m or above, more preferably 0.015 $\mu$m or above. Especially preferably the surface of the other side of the release layer has the above center-line average height. A laminated film having a center-line average height within the range has good slipperiness.

(Thickness of Laminated Film)

The thickness of the laminated film of the present invention is preferably 2 to 200 $\mu$m, more preferably 8 to 100

μm, and especially preferably 10 to 25 μm. A laminated film thicker than 200 μm is undesirable because the resolution is lowered when the film is used as a dry film photoresist. A film thinner than 2 μm has insufficient strength to frequently cause the breakage especially in the release process.

(Light Transmittance of Laminated Film)

The laminated film of the present invention has a light transmittance at 365 nm wavelength, namely an ultraviolet transmittance, of 80% or over, preferably 85% or over, more preferably 86% or over and especially preferably 87% or over for increasing the resolution. When the ultraviolet transmittance is smaller than 80%, the exposure and hardening steps of the photoresist layer sometimes fail in smooth completion resulting in a poor resolution.

(Haze of Laminated Film)

The laminated film of the present invention has a haze value of preferably 5% or below, more preferably 4% or below and especially preferably 1% or below. A laminated film having a haze value within the above range gives excellent transparency and high resolution when the laminated film is used for the dry film photoresist.

(Air Escape Rate of Laminated Film)

The air escape rate between the films of the laminated film of the present invention is preferably 10 to 120 mmHg/hr. The windability of the film is agreeable when the air escape rate is within the above range. The air escape rate between films is measured by stacking 20 sheets of the film specimens cut to the size of 8 cm × 5 cm, opening a regular triangular hole having a side length of 2 mm at the center of each of the lower 19 sheets out of 20 sheets and measuring the pressure drop in terms of mmHg/hr by using a digital Bekk smoothness tester (product of Toyo Seiki Seisaku-sho, Ltd.).

(Thermal Shrinkage of Laminated Film)

The longitudinal thermal shrinkage of the laminated film of the present invention measured at 150°C is preferably 1.0 to 5.0%. When the longitudinal thermal shrinkage is lower than 1.0%, the flatness and the transparency of the film are sometimes deteriorated to cause troubles in the production process and electronic circuit production process in the case of using the laminated film of the present invention for dry film photoresist. The longitudinal thermal shrinkage exceeding 5.0% is also unfavorable owing to the tendency of shrinkage and deformation by the heat and solvent in individual steps.

(Multilayer Film)

The polyester film of the laminated film of the present invention may be composed of a single layer or two or more layers. For example, as described in the Japanese Unexamined Patent Publication No.7-333,853, a polyester composed of two or more layers and containing porous silica particles in the outermost layer can be used as the polyester film.

[Substrate for Photoresist]

(Photoresist layer)

The laminated film of the present invention is especially suitable as a dry film photoresist coverless film (substrate for photoresist). More specifically, a dry film photoresist coverless film can be produced by forming a photoresist layer on at least one surface of the laminated film of the present invention.

Examples

The present invention is further explained by the following Examples. The physical properties and characteristics in the Examples are measured and defined by the following methods.

(1) Quantitative analysis of antimony

A polyester film is melted and formed to a plate of 5 cm diameter and 3 mm thick and antimony is quantitatively determined by fluorescent X-ray analysis (RIX3000, product of Rigaku Corp.). The metal of the anode of the X-ray tube is Cr or Rh. A calibration line (abscissa: the amount of antimony, ordinate: the detected counts (cps) by antimony analysis) is prepared by using samples of known antimony contents and the quantity of antimony in an unknown specimen is determined from the detected counts of antimony (unit: cps).

(2) Intrinsic viscosity

Intrinsic viscosity is measured by using an o-chlorophenol solution at 35°C.

(3) Film thickness

The film thickness is measured by an external micrometer at one hundred points and the average value is used as the film thickness.

(3) Melting point

The melting peak is measured by DuPont Instruments 910 DSC at a heating rate of 20°C/min. The amount of the specimen is 20 mg.

(4) Average diameter of particles (Examples 1 to 13 and Comparative Examples 1 to 9)

(a) Primary particle

The average diameter of primary particles is determined by scattering the silica particles in a manner to prevent the overlap of individual particles as much as possible, forming a gold sputtered layer of the thickness of 200 to 300 A on the surface of the scattered particles by a gold sputtering apparatus, observing them by a scanning electron microscope at a magnification of 10,000 to 30,000, processing the obtained image by using LUZEX 500 (product of Nireco Corp.) and calculating the average diameter from the data of 100 particles.

(b) Secondary particle

The average diameter of the secondary particles consisting of aggregate of primary particles is defined as the diameter corresponding to 50% fraction of the cumulative volume in an equivalent spherical distribution measured by a centrifugal precipitation particle size distribution analyzer.

(5) Average diameter of particles (Examples 14 to 31 and Comparative Examples 10 to 19)

(a) Primary particle

The average diameter of primary particles is measured by using Centrifugal Particle Analyzer Type CP-50 manufactured by Shimadzu Corp. The particle diameter corresponding to 50 mass % in a calculated cumulative curve showing the relationship between each particle diameter and the residual amount of the particles based on the obtained centrifugal precipitation curve, is defined as the average particle diameter (refer to the Book "Particle Size Measuring Technique" published by the Nikkan Kogyo Shimbun, Ltd., 1975, p.242-247).

(b) Secondary particle

Sample for determining the average diameter of the secondary particles consisting of aggregate of the primary particles is prepared by cutting a film containing the particles to ultra-thin slices of the cross-section having a thickness of 100 nm and taking photos of the agglomerated particles (secondary particles) through a transmission electron microscope (JEM-1200EX manufactured by JEOL, Ltd.) at a magnification of about 10,000. The particles are observed on the photographs and the particle diameter is determined as the diameter of a circle having the same area of the particle by using an image analyzer, etc., and the number-average diameter of 1,000 particles is used as the average secondary diameter. The material of the particle can be determined e.g. by the quantitative analysis of metallic elements using SEM-XMA, ICP, etc.

(6) Pore volume

Pore volume is measured by nitrogen adsorption and desorption method and calculated by BET equation.

(7) Size and number of coarse particles in the film

The light transmission image of the film is magnified 20 times by a universal projector and the number of particles having maximum dimension of 50 $\mu$m or larger are counted. The measuring area of the film is 1 m$^2$.

(8) Center line average height (Ra)

The center line average height is determined by following the procedure of JISB0601 by using the high-precision surface roughness tester SE-3FAT manufactured by Kosaka Laboratory Ltd., under the condition of a stylus having a tip radius of 2 $\mu$m at load of 30 mg, a magnification ratio of 200,000 and a cut-off of 0.08 mm. A part of the obtained surface roughness curve having a measurement length L is extracted and the average height is calculated by the following formula and the calculated value is expressed by $\mu$m unit. In the formula, the X axis is the center line of the extracted part, the Y axis is the direction of the vertical magnification and the roughness curve is expressed by y=f(x).

$$Ra = \frac{1}{L}\int_{L_0}^{L_1}|f(x)|dx$$

(9) Characteristics of photoresist film

A printed circuit is produced by using the obtained photoresist film and the resolution and the circuit defect are evaluated. Concretely, a photoresist layer of a photoresist film is closely contacted, after peeling the protection layer, with a copper plate formed on an epoxy resin plate containing glass fiber. A glass plate having printed circuit is closely contacted with the laminate film. The resist layer is exposed with ultraviolet rays from the side of the glass plate. Then the photoresist film is peeled off. The product is washed and etched. The resolution and circuit defects of the obtained circuit are observed visually or with a microscope and the result is evaluated according to the following criteria.

(a) Resolution

◎ : The resolution is extremely high to get a sharp circuit.
O : The resolution is high to get a sharp circuit.
$\Delta$ : The resolution is rather poor to produce a phenomenon such as the thickening of line.
$\times$ : The resolution is poor to fail in getting a practically usable circuit.

(b) Circuit defect

$\bigcirc$ : The circuit defect is not recognizable.
$\Delta$ : The circuit defects are sparsely recognizable.
$\times$ : Many circuit defects are observable and the product is unsuitable for practical use.

(10) Releasability of photoresist layer

A photo-sensitive composition (photoresist) composed of a polymethyl methacrylate as a binder, trimethylolpropane triacrylate as a crosslinking agent, anthraquinone as a photopolymerization initiator, hydroquinone as a stabilizer and Methyl Violet as a coloring agent is coated to a polyester film surface of the other side of the release layer in a dark room to a thickness of 0.02 mm. A pair of the produced sheets are stacked in a manner to contact the release layer surface with the photoresist layer surface and laminated under pressure of a roller of 2 kg weight and the roller is moved once back and forth. A specimen for the evaluation of releasability is obtained. The releasability of a specimen immediately after lamination is measured by peeling the release treated surface of the release-treated polyester film from the photoresist surface at an angle of 180° and a speed of 300 mm/min and the result is evaluated by the following criteria.

○ : The release force is low to leave no photoresist residue on the polyester film.
Δ : The release force is medium to leave a small amount of photoresist residue on the polyester film.
× : The release force is high to leave the most part of the photoresist on the polyester film.

(11) Water contact angle ($\theta Y$, $\theta R$)

A specimen is set on a contact angle measuring apparatus (product of Elmer Corp.) putting the measuring surface upward, a water droplet is dropped on the specimen at 23°C and the contact angle is measured after 1 minute. The average of three contact angle measurement is used as the water contact angle.

(12) Slipperiness

The slipperiness is evaluated by the following three levels in a winding process including the slitting during the film manufacturing and a process producing the above photoresist film.

○ : The film is free from the generation of crease and there is no problem. Δ : Crease is generated occasionally on the film.
× : Crease is constantly observable on a part of or the whole surface of the film.

(13) Unwindability

A photo-sensitive composition (photoresist) composed of a polymethyl methacrylate as a binder, trimethylolpropane triacrylate as a crosslinking agent, anthraquinone as a photopolymerization initiator, hydroquinone as a stabilizer and Methyl Violet as a coloring agent is coated to the surface Y of a polyester film in a dark room to a thickness of 0.02 mm. The obtained laminated film is wound in the form of a roll in a manner to contact the surface of the photoresist layer closely with the surface X of the other side of the photoresist or the release layer surface R of the laminated polyester film. The roll is unwound at a speed of 300 mm/min and the unwindability is visually observed and evaluated by the following criterion.

◎ : The release at the interface between the photoresist layer and the surface X of the polyester film or the release layer surface R is light release and there is absolutely no residue of the photoresist on the surface X or the release layer surface R.
○ : The release at the interface between the photoresist layer and the surface X of the polyester film or the release layer surface R is medium release and there is a certain amount of residue of the photoresist on the surface X or the release layer surface R.
× : The release at the interface between the photoresist layer and the surface X of the polyester film or the release layer surface R is heavy release and the most part of the photoresist is left on the surface X or the release layer surface R.

(14) Air Escape Rate of Film

The windability of the film is defined by the air escape rate of the film in stacked state. The deaeration rate is measured by stacking 20 sheets of the film specimens cut to the size of 8 cm × 5 cm, opening a regular triangular hole having a side length of 2 mm at the center of each of the lower 19 sheets out of 20 sheets and measuring the pressure drop per unit time (mmHg/hr) by using a digital Bekk smoothness tester (product of Toyo Seiki Seisaku-sho, Ltd.).

(15) Ultraviolet transmittance

The transmittance of ultraviolet ray of 365 nm wavelength is measured by using the spectrophotometer MPC-3100 manufactured by Shimadzu Corp.

(16) Light transmittance

The haze value of a film is measured in conformity to JIS P-8116 by using a haze tester (NDH-20) manufactured by Nippon Denshoku Ind. Col, Ltd.

(17) Thermal shrinkage

A film having an accurately measured length is placed in a tension-free state in a constant temperature chamber set at 130 °C, maintained for 30 minutes, taken out from the chamber and cooled to the room temperature, and the dimensional change is measured. The thermal shrinkage is calculated by the following formula wherein L0 is the length before heat-treatment and L is the length after heat-treatment.

$$\text{Thermal shrinkage} = (L_0 - L) \times 100 / L_0 \ (\%)$$

Example 1

(An example to use a silicone resin as the release layer)

A polyethylene terephthalate having an intrinsic viscosity of 0.65 dl/g (o-chlorophenol, 35 °C) was produced by carrying out the transesterification reaction and polycondensation reaction of dimethyl terephthalate and ethylene glycol by adding manganese acetate as a transesterification catalyst, germanium oxide as a polymerization catalyst, phosphorous acid as a stabilizer and 0.01 wt.% porous silica particles having a pore volume of 1.6 ml/g and an average particle diameter of 1.5 $\mu$m and consisting of aggregate (secondary particle) of primary particles having an average particle diameter of 0.02 $\mu$m.

The pellets of the obtained polyethylene terephthalate were dried at 170°C for 3 hours, supplied to the hopper of an extruder, melted at 290°C, filtered with a nonwoven filter having an average mesh opening of 24 $\mu$m and made of thin stainless steel fibers having the diameter of 13 $\mu$m. The filtered polymer was extruded through a slit die and cast on a chilled rotary drum having a surface finish of about 0.3s and a surface temperature of 20°C to obtain an undrawn film. The undrawn film produced by the above method was preheated at 75°C and longitudinally drawn 3.7 times between a low-speed roller and a high-speed roller while the film is heated by a single infrared heater of a surface temperature of 800°C placed between the above rollers and 15 mm above the film to obtain a longitudinally drawn film.

The following coating liquid for forming the release layer A was coated to a surface of the longitudinally drawn film with a gravure coater in a manner to get a thickness of 0.1 $\mu$m after drying and lateral drawing procedures.

(Coating liquid to form the release layer A) (silicone resin)

A 10% aqueous solution containing DEHESIVE 39005VP produced by Wacker Asahikasei Silicone Co., Ltd. (100 parts by weight), DEHESIVE 39006VP (100 parts by weight) and A-187 produced by Nippon Unicar Co., Ltd. (2 parts by weight).

The coated film was led to a tenter, drawn in lateral direction at 110°C and a drawing ratio of 4.0 and heat-set at 235°C for 5 seconds to obtain a biaxially oriented laminated polyester film having a film thickness of 25 $\mu$m.

A photoresist layer was laminated to the surface of the produced laminated polyester film at the other side of the release layer, a printed circuit was formed on the surface and the characteristics were evaluated. The results are shown in the Table 1.

Examples 2 and 3, and Comparative Examples 1 and 2

(Examples of various content of the porous silica particle in the polyester)

A biaxially oriented laminated polyester film having a film thickness of 25 $\mu$m was produced by a method same as the Example 1 except for the change of the addition amount of the porous silica particle to the level shown in the Table 1.

A printed circuit was formed by laminating a photoresist layer to a surface of the obtained laminated polyester film at the other side of the release layer and the characteristics of the circuit were evaluated. The results are shown in the Table 1.

The average particle diameter of the primary particle of the porous silica particle used in the Example 2, the pore volume, the average particle diameter, the amount of Sb in the polyester and the concentration of the residual catalyst are shown in the Table 2. A printed circuit was formed by laminating a photoresist layer to a surface of the laminated polyester film obtained by the Example 2 at the other side of the laminated release layer and the characteristics of the circuit were evaluated. The results are shown in the Table 3.

Example 4

(An example to use a fluororesin layer as the release layer)

The setting of the average particle diameter of the primary particle, the pore volume of the porous silica particle, the average particle diameter of the porous silica particle, the amount of Sb and the catalyst residue to the state are shown in the Table 2, and a biaxially oriented laminated polyester film was produced by a method same as the Example 2 except for the coating of a 15% aqueous solution of Surflon S-112 (product of Asahi Glass Co., Ltd.) by a roll coater to one surface of the longitudinally drawn film in order to get a release layer B having a layer thickness of 0.05 $\mu$m after the drying and lateral drawing procedures.

A printed circuit was formed by using the obtained laminated polyester film and laminating a photoresist layer on the other surface of the laminated release layer and the characteristics of the circuit were evaluated. The results are shown in the Table 3.

Example 5

(An example of an olefin resin layer as the release layer)

The setting of the average particle diameter of the primary particle, the pore volume of the porous silica particle, the average particle diameter of the porous silica particle, the amount of Sb and the catalyst residue to the state are shown in the Table 2. Pellets of a polyethylene terephthalate produced by a method same as the Example 2 were dried at 170°C for 3 hours, supplied to the hopper of an extruder, melted at a melting temperature of 290°C, filtered with a nonwoven filter composed of thin stainless steel fiber having a fiber diameter of 13 $\mu$m and an average mesh opening of 24 $\mu$m, extruded through a slit die, and cast on a chilled rotary drum having a surface finish of about 0.3s and a surface temperature of 20°C to obtain an undrawn film. The obtained undrawn film was preheated at 75°C and drawn in longitudinal direction at a draw ratio of 3.7 between a low-speed roller and a high-speed roller under heating with a single infrared heater having a surface temperature of 800°C and placed 15 mm above the film. The obtained longitudinally drawn film was led to a tenter, drawn 4.0 times in lateral direction at 110°C and heat-set at 235°C for 5 seconds to obtain a biaxially oriented polyester film having a film thickness of 25 $\mu$m.

A release agent coating liquid having a solid concentration of 1% and produced by dissolving an alkyl-modified polyethyleneimine (PR-10, product of Nippon Shokubai Co., Ltd.) in a methyl ethyl ketone/toluene mixed solvent was coated in a manner similar to the Example 2 of the Japanese Patent 2,882,953 as a release layer C to the other surface of the obtained biaxially drawn polyester film of the laminated release layer in an amount of 10 g/m$^2$ and dried. The thickness of the release layer film was 0.1 $\mu$m.

A photoresist layer was laminated to the obtained laminated polyester film on the other surface of the release layer and the characteristics of the produced printed circuit were evaluated. The results are shown in the Table 3.

Example 6

(An example to apply a polyvinyl carbamate layer as the release layer)

The setting of the average particle diameter of the primary particle, the pore volume of the porous silica particle, the average particle diameter of the porous silica particle, the amount of Sb and the catalyst residue are shown in the Table 2. A biaxially oriented laminated polyester film was produced by a method same as the Example 2 except for the coating of 5% aqueous solution of Peeloil 406 (product of Ipposha Oil Ind. Co., Ltd.) as the release layer D by a roll coater to a surface of the longitudinally drawn film in order to get a release layer having a thickness of 0.05 $\mu$m after the drying and lateral drawing procedures.

A photoresist layer was laminated to the obtained laminated polyester film on the other surface of the release layer and the characteristics of the produced printed circuit were evaluated. The results are shown in the Table 3.

Example 7

(An example to apply a wax layer as the release layer)

The setting of the average particle diameter of the primary particle, the pore volume of the porous silica particle, the average particle diameter of the porous silica particle, the amount of Sb and the catalyst residue are shown in the Table 2. A biaxially oriented laminated polyester film was produced by a method same as the Example 2 except for the coating of 10% aqueous solution of EV-4 (219 parts by weight) and Himicron G-270 (137 parts by weight) (products of Chukyo Yushi. Co., Ltd.) as the release layer E by a roll coater to a surface of the longitudinally drawn film in order to get a release layer having a thickness of 0.05 μm after the drying and lateral drawing procedures.

A photoresist layer was laminated to the obtained laminated polyester film on the other surface of the release layer and the characteristics of the produced printed circuit were evaluated. The results are shown in the Table 3.

Example 8

(An example to apply an olefin resin layer as a release layer by extrusion lamination)

A medium-density polyethylene was applied in a manner similar to the Example 1 of the Japanese Patent 2,882,953 as a release layer F to a biaxially drawn polyester film obtained by a method similar to the Example 5 on the other surface of the laminated release layer to a thickness of 15 μm.

A layer was laminated to the obtained laminated polyester film on the other surface of the release layer and the characteristics of the produced printed circuit were evaluated. The results are shown in the Table 3.

Examples 9 to 13 and Comparative Examples 3 and 5 to 9

The setting of the average particle diameter of the primary particle, the pore volume of the porous silica particle, the average particle diameter of the porous silica particle, the amount of Sb, the catalyst residue and the release layer are shown in the Table 2, and biaxially drawn polyester films were produced by a method similar to the Example 2.

A photoresist layer was laminated to each of the obtained laminated polyester film on the other surface of the release layer and the characteristics of the produced printed circuit were evaluated. The results are shown in the Table 3.

Comparative Example 4

A photoresist layer was laminated on the other surface of the release layer of a biaxially oriented polyester film produced by a method similar to the Example 5 and the characteristics of produced printed circuit were evaluated. The results are shown in the Table 3.

Table 1

| | Silica | | Release layer | UV transmittance % | Ra μm | Haze % | No. of coarse particles No./m² | Resolution | Circuit defect | Slipperiness |
|---|---|---|---|---|---|---|---|---|---|---|
| | Kind | Addition amount wt.% | | | | | | | | |
| Example 1 | Porous | 0.01 | A | 87.0 | 0.012 | 1.3 | 1 | ○ | ○ | ○ |
| Example 2 | Porous | 0.05 | A | 86.5 | 0.030 | 3.0 | 2 | ○ | ○ | ○ |
| Example 3 | Porous | 0.10 | A | 85.9 | 0.039 | 4.7 | 4 | ○ | ○ | ○ |
| Comp. Example 1 | Porous | 0.15 | A | 79.2 | 0.046 | 7.0 | 6 | × | × | ○ |
| Comp. Example 2 | Spherical | 0.02 | A | 79.5 | 0.015 | 3.7 | 1 | ○ | ○ | × |

Table 2

| | Average diameter Primary Particle μm | Pore volume Secondary Particle ml/g | Average diameter Secondary Particle μm | Amount of Sb element mmol% | Metal Catalyst Residue ppm | Release Layer |
|---|---|---|---|---|---|---|
| Comp. Example 3 | 0.005 | 1.2 | 1.5 | 0 | 100 | A |
| Comp. Example 4 | 0.02 | 1.6 | 1.5 | 0 | 100 | none |
| Example 2 | 0.02 | 1.6 | 1.5 | 0 | 100 | A |
| Example 4 | 0.02 | 1.6 | 1.5 | 0 | 100 | B |
| Example 5 | 0.02 | 1.6 | 1.5 | 0 | 100 | C |
| Example 6 | 0.02 | 1.6 | 1.5 | 0 | 100 | D |
| Example 7 | 0.02 | 1.6 | 1.5 | 0 | 100 | E |
| Example 8 | 0.02 | 1.6 | 1.5 | 0 | 100 | F |
| Comp. Example 5 | 0.12 | 1.2 | 1.5 | 0 | 100 | A |
| Comp. Example 6 | 0.05 | 0.3 | 1.5 | 0 | 100 | A |
| Example 9 | 0.05 | 0.6 | 1.5 | 0 | 100 | A |
| Example 10 | 0.05 | 1.9 | 1.5 | 0 | 100 | A |
| Comp. Example 7 | 0.05 | 2.1 | 1.5 | 0 | 100 | A |
| Example 11 | 0.05 | 1.2 | 0.1 | 0 | 100 | A |
| Example 12 | 0.05 | 1.2 | 4.8 | 0 | 100 | A |
| Comp. Example 8 | 0.05 | 1.2 | 5.2 | 0 | 100 | A |
| Example 13 | 0.05 | 1.2 | 1.5 | 10 | 140 | A |
| Comp. Example 9 | 0.05 | 1.2 | 1.5 | 16 | 200 | A |

Table 3

| | UV Transmittance % | Rs μm | Haze % | No. of Coarse Particle No/m² | Resolution | Circuit defect | Slip periness | Releasability of photoresist |
|---|---|---|---|---|---|---|---|---|
| Comp. Example 3 | 79.8 | 0.030 | 2.7 | 7 | × | Δ | ○ | ○ |

(continued)

| | UV Transmittance % | Rs μm | Haze % | No. of Coarse Particle No/m$^2$ | Resolution | Circuit defect | Slip periness | Releasability of photoresist |
|---|---|---|---|---|---|---|---|---|
| Comp. Example 4 | 84.4 | 0.028 | 2.9 | 2 | ○ | ○ | ○ | × |
| Example 2 | 86.5 | 0.030 | 3.0 | 2 | ○ | ○ | ○ | ○ |
| Example 4 | 86.0 | 0.031 | 3.0 | 2 | ○ | ○ | ○ | ○ |
| Example 5 | 85.2 | 0.029 | 3.3 | 1 | ○ | ○ | ○ | ○ |
| Example 6 | 84.7 | 0.030 | 3.5 | 2 | ○ | ○ | ○ | ○ |
| Example 7 | 86.6 | 0.032 | 2.9 | 3 | ○ | ○ | ○ | ○ |
| Example 8 | 85.9 | 0.031 | 3.1 | 2 | O | O | ○ | ○ |
| Comp. Example 5 | 78.9 | 0.035 | 5.2 | 4 | × | × | ○ | ○ |
| Comp. Example 6 | 78.7 | 0.032 | 5.5 | 4 | × | × | ○ | ○ |
| Example 9 | 85.0 | 0.031 | 4.0 | 2 | ○ | ○ | ○ | ○ |
| Example 10 | 86.0 | 0.028 | 2.7 | 6 | ○ | ○ | ○ | ○ |
| Comp. Example 7 | 79.7 | 0.027 | 2.5 | 11 | × | × | ○ | ○ |
| Example 11 | 86.1 | 0.012 | 1.2 | 4 | ○ | ○ | ○ | ○ |
| Example 12 | 85.7 | 0.043 | 4.8 | 3 | ○ | ○ | ○ | ○ |
| Comp. Example 8 | 78.7 | 0.043 | 5.2 | 3 | × | × | ○ | ○ |
| Example 13 | 86.1 | 0.030 | 3.1 | 0 | ○ | ○ | ○ | ○ |
| Comp. Example 9 | 78.3 | 0.031 | 3.2 | 0 | × | × | ○ | ○ |

The abbreviations in the release layer column of the Tables 1 and 2 mean the lamination of the following release layers.

A : Release layer A is laminated.
B : Release layer B is laminated.
C : Release layer C is laminated.
D : Release layer D is laminated.
E : Release layer E is laminated.
F : Release layer F is laminated.
none: No release layer is laminated.

It is obvious from the results shown in the Tables 1 to 3 that the laminated films of the present invention have excellent releasability of photoresist layer, ultraviolet ray transmittance and photoresist film properties.

Example 14

(An example to use a silicone resin as the release layer)

A polyethylene terephthalate having an intrinsic viscosity of 0.65 dl/g (o-chlorophenol, 35°C) was produced by carrying out the polymerization reaction of dimethyl terephthalate and ethylene glycol by conventional method adding manganese acetate as a transesterification catalyst, germanium oxide as a polymerization catalyst, phosphorous acid as a stabilizer and porous silica particles consisting of aggregate (secondary particle) and having an average particle diameter of 1.7 $\mu$m in an amount of 0.066% by weight based on the produced polymer. The pellets of the obtained polyethylene terephthalate were dried at 170°C for 3 hours, supplied to an extruder, melted at 295°C, filtered with a nonwoven filter having an average mesh opening of 24 $\mu$m and made of thin stainless steel fibers having the diameter of 13 $\mu$m. The filtered polymer was extruded through a T-shaped die and cast on a chilled rotary drum having a surface finish of about 0.3s and a surface temperature of 20°C to obtain an undrawn film having a thickness of 225 $\mu$m. The undrawn film produced by the above method was preheated at 75°C and longitudinally drawn 3.6 times between a low-speed roller and a high-speed roller while the film is heated by a single infrared heater of a surface temperature of 800°C placed between the above rollers and 15 mm above the film and quenched to obtain a longitudinally drawn film.
The following coating liquid for forming the release layer A was coated to a surface of the longitudinally drawn film by a roll coater in a manner to get a thickness of 0.1 $\mu$m after the drying and lateral drawing procedures.

(Coating liquid to form the release layer A) (silicone resin)

A 5% aqueous solution containing DEHESIVE 39005VP produced by Wacker Asahikasei Silicone Co., Ltd. (100 parts by weight), DEHESIVE 39006VP (100 parts by weight) and A-187 produced by Nippon Unicar Co., Ltd. (2 parts by weight).
The coated film was led to a tenter, drawn in lateral direction at 120°C and a drawing ratio of 3.9 and the biaxially oriented film was heat-set at 205°C for 5 seconds to obtain a laminated polyester film having a film thickness of 16 $\mu$m. The intrinsic viscosity of the polyester constituting the film was 0.61 dl/g.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 15

(An example to vary the intrinsic viscosity and the thickness of the polyester film)

A laminated polyester film having a thickness of 23 pm and composed of a polyethylene terephthalate having an intrinsic viscosity of 0.56 dl/g was produced by a method similar to the Example 1 except for the use of a polyethylene terephthalate having an intrinsic viscosity of 0.60 dl/g for melt-extrusion and the setting of the thickness of the undrawn film to 323 $\mu$m.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 16

(An example to vary the antimony concentration in the polyester)

A biaxially oriented polyester film having a thickness of 16 μm was produced by a method similar to the Example 14 except for the addition of antimony trioxide as a catalyst in an amount shown in the Table 4.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 17

(An example to apply a fluororesin layer as the release layer)

A laminated polyester film was produced by a method similar to the Example 14 except for coating of 10% aqueous solution of Surflon S-112 (product of Asahi Glass Co., Ltd.) as a release layer B' to a surface of a longitudinally drawn film produced by a method similar to the Example 14 by a roll coater in an amount to form a release layer thickness of 0.05 μm after the drying and lateral drawing procedures.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 18

(An example to apply an olefin resin layer as the release layer)

A biaxially oriented polyester film having a thickness of 16 μm and no laminated release layers on both surfaces was produced in a manner similar to the Example 14 without coating a liquid to a longitudinally drawn film.
The coating liquid of the release agent having a solid concentration of 1% and produced by dissolving an alkyl-modified polyethyleneimine (PR-10, product of Nippon Shokubai Co., Ltd.) in a methyl ethyl ketone/toluene mixed solvent was coated as a release layer C in a manner similar to the Example 2 of the Japanese Patent 2,882,953 to a surface of the obtained biaxially oriented polyester film in an amount of 10 g/m$^2$ and dried. The thickness of the release layer coating film was 0.1 μm.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 19

(An example to apply a polyvinyl carbamate layer as the release layer)

A laminated polyester film was produced by a method similar to the Example 14 except for coating of 5% aqueous solution of Peeloil 406 (product of Ipposha Oil Ind. Co., Ltd.) as the release layer D by a roll coater to a surface of a longitudinally drawn film produced by a method similar to the Example 14 to get a release layer having a thickness of 0.05 μm after the drying and lateral drawing procedures.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 20

(An example to apply a wax layer as the release layer)

A laminated polyester film was produced by a method similar to the Example 14 except for coating of 10% aqueous solution of EV-4 (219 parts by weight) and Himicron G-270 (137 parts by weight) (products of Chukyo Yushi. Co., Ltd.) as the release layer E by a roll coater to a surface of a longitudinally drawn film produced by a method similar to the Example 14 to get a release layer having a thickness of 0.05 μm after the drying and lateral drawing procedures.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Example 21

(An example to apply an olefin resin layer as the release layer by extrusion lamination)

A medium density polyethylene was laminated by an extrusion lamination method at a thickness of 15 $\mu$m to a surface of a biaxially oriented polyester film with no release layers on both surfaces and obtained by a method similar to the Example 18 in a manner similar to the Example 14 of the Japanese Patent 2,882,953.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.

Examples 22 and 23

(Examples to vary the addition amount of lubricant)

Laminated polyester films were produced in a manner similar to the Example 14 except for the setting of the addition amount level of the lubricant described in the Table 4.
A photoresist layer was laminated to the surface of the produced laminated polyester film at the other side of the release layer, a printed circuit was formed on the surface and the characteristics of the photoresist film were evaluated. The results and the characteristics of the plain film are shown in the Table 4.
Although omitted in the Table, the air escape rates of the films of the Examples 14 to 23 were within the range of 30 to 100 mmHg/hr and the thermal shrinkages were within the range of 1.0 to 5.0% and they are in the good range.

Comparative Example 10

A laminated polyester film having a thickness of 8 $\mu$m and composed of a polyethylene terephthalate having an intrinsic viscosity of 0.50 dl/g was produced in a manner similar to the Example 14 except for the use of a polyethylene terephthalate having an intrinsic viscosity of 0.55 dl/g for melt-extrusion and setting the thickness of the undrawn film to 112 $\mu$m.
The film of the Comparative Example 10 was frequently broken at the timing of releasing from the photoresist to fail in the production of a printed circuit.

Comparative Example 11

A laminated polyester film having a thickness of 16 $\mu$m was produced in a manner similar to the Example 14 except for the addition of antimony trioxide as a condensation catalyst in an amount shown in the Table 4.
A photoresist layer was laminated to the obtained laminated polyester film on the other surface of the release layer, a printed circuit was formed on the surface and the characteristics of the photoresist film were evaluated. The results and the characteristics of the plain film are shown in the Table 4.

Comparative Example 12

A biaxially oriented polyester film with no release layers on both surfaces was produced by a method similar to the Example 18.
A photoresist layer was laminated to a surface of the obtained laminated polyester film, a printed circuit was formed on the surface and the characteristics of the photoresist film were evaluated. A photoresist layer was laminated to the other surface of the obtained laminated polyester film and the peelability of the photoresist was evaluated. The results and the characteristics of the plain film are shown in the Table 4.

Comparative Examples 13 to 15

Laminated polyester films having a thickness of 16 $\mu$m were produced by a method similar to the Example 14 except for the setting of the addition amount of antimony trioxide, the kind of the lubricant, the average particle diameter and the addition amount to the states shown in the Table 4.
A photoresist layer was laminated to the obtained laminated polyester film on the other surface of the release layer, a printed circuit was formed on the surface and the characteristics of the photoresist film were evaluated. The results and the characteristics of the plain film are shown in the Table 4.

Table 4

| | Amount of Sb in Film ppm | Catalyst residue in film ppm | Intrinsic viscosity dl/g | Lubricant | | | Release layer | Thickness μm | Haze % | UV trarismitt ance % | photoresist film properties | | peelability of photo resist |
| | | | | Kind | Average diameter μm | Addition amount wt.% | | | | | resolution | circuit defect | |
|---|---|---|---|---|---|---|---|---|---|---|---|---|---|
| Comparative Example 10 | 0 | 100 | 0.50 | porous silica | 1.7 | 0.066 | A | 8 | 1.0 | 88.2 | - | - | - |
| Example 14 | 0 | 100 | 0.61 | porous silica | 1.7 | 0.066 | A | 16 | 2.3 | 87.8 | ◎ | ○ | ○ |
| Example 15 | 0 | 100 | 0.56 | porous silica | 1.7 | 0.066 | A | 23 | 2.8 | 86.3 | ○ | ○ | ○ |
| Example 16 | 10 | 140 | 0.61 | porous silica | 1.7 | 0.066 | A | 16 | 2.5 | 86.1 | ○ | ○ | ○ |
| Comparative Example 11 | 16 | 200 | 0.61 | porous silica | 1.7 | 0.066 | A | 16 | 2.4 | 79.2 | × | × | ○ |
| Comparative Example 12 | 0 | 100 | 0.61 | porous silica | 1.7 | 0.066 | none | 16 | 2.4 | 84.8 | ○ | ○ | × |
| Example 17 | 0 | 100 | 0.61 | porous silica | 1.7 | 0.066 | B | 16 | 2.5 | 87.0 | ◎ | ○ | ○ |
| Example 18 | 0 | 100 | 0.61 | porous silica | 1.7 | 0.066 | C | 16 | 2.7 | 86.3 | ○ | ○ | ○ |
| Example 19 | 0 | 100 | 0.61 | porous silica | 1.7 | 0.066 | D | 16 | 2.8 | 85.4 | ○ | ○ | ○ |
| Example 20 | 0 | 100 | 0.61 | porous silica | 1.7 | 0.066 | E | 16 | 2.6 | 87.0 | ◎ | ○ | ○ |
| Example 21 | 0 | 100 | 0.61 | porous silica | 1.7 | 0.066 | F | 31 | 2.7 | 86.6 | ○ | ○ | ○ |
| Example 22 | 0 | 100 | 0.61 | porous silica | 1.7 | 0.030 | A | 16 | 1.4 | 87.2 | ◎ | ○ | ○ |
| Example 23 | 0 | 100 | 0.61 | porous silica | 1.7 | 0.085 | A | 16 | 2.9 | 86.6 | ○ | ○ | ○ |
| Comparative Example 13 | 16 | 200 | 0.61 | porous silica | 1.7 | 0.120 | A | 16 | 5.2 | 78.9 | × | × | ○ |
| Comparative Example 14 | 16 | 200 | 0.61 | porous silica | 3.2 | 0.066 | A | 16 | 5.3 | 78.8 | × | × | ○ |
| Comparative Example 15 | 16 | 200 | 0.61 | spherical silica | 1.7 | 0.066 | A | 16 | 5.1 | 79.0 | × | Δ | ○ |

The abbreviations in the release layer column of the Table 4 mean the lamination of the following release layers.

A : Release layer A is laminated.
B : Release layer B is laminated.
C : Release layer C is laminated.
D : Release layer D is laminated.
E : Release layer E is laminated.
F : Release layer F is laminated.
none: No release layer is laminated.

It is obvious from the results shown in the Table 4 that the laminated films of the present invention have excellent releasability of photoresist layer, ultraviolet ray transmittance and photoresist film properties.

Example 24

(An example to apply a silicone resin layer as the release layer)

A polyethylene terephthalate having an intrinsic viscosity of 0.65 dl/g (o-chlorophenol, 35°C) was produced by carrying out the polymerization reaction of dimethyl terephthalate and ethylene glycol by conventional method adding manganese acetate as a transesterification catalyst, germanium oxide as a polymerization catalyst, phosphorous acid as a stabilizer and porous silica particles consisting of aggregate (secondary particle) and having an average particle diameter of 1.7 $\mu$m as a lubricant in an amount of 0.066% by weight based on the produced polymer. The pellets of the obtained polyethylene terephthalate were dried at 170°C for 3 hours, supplied to an extruder, melted at 295°C, filtered with a nonwoven filter having an average mesh opening of 24 $\mu$m and made of thin stainless steel fibers having the diameter of 13 $\mu$m. The filtered polymer was extruded through a T-shaped die and cast on a chilled rotary drum having a surface finish of about 0.3s and a surface temperature of 20°C to obtain an undrawn film having a thickness of 225 $\mu$m. The undrawn film produced by the above method was preheated at 75°C and longitudinally drawn 3.6 times between a low-speed roller and a high-speed roller while the film is headed by a single infrared heater of a surface temperature of 800°C placed between the above rollers and 15 mm above the film and then quenched to obtain a longitudinally drawn film.
The following coating liquid for forming the release layer A was coated to a surface (surface X) of the longitudinally drawn film by a roll coater in a manner to get a thickness of 0.05 $\mu$m after the drying and lateral drawing procedures.

(Coating liquid to form the release layer A) (silicone resin)

A 10% aqueous solution containing DEHESIVE 39005VP produced by Wacker Asahikasei Silicone Co., Ltd. (100 parts by weight), DEHESIVE 39006VP (100 parts by weight) and A-187 produced by Nippon Unicar Co., Ltd. (2 parts by weight).
The coated film was led to a tenter and drawn in lateral direction at 120°C and a drawing ratio of 3.9, and the biaxially oriented film was heat-set at 205°C for 5 seconds and wound in the form of a roll to obtain a film roll of the biaxially oriented laminated polyester film having a thickness of 20 $\mu$m, a surface R of laminated release layer A and a surface Y without any laminated layer.
The obtained roll of the laminated polyester film was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 25

(An example to apply corona discharge treatment on the surface free from the release layer)

Corona discharge treatment was carried out on the surface Y of a biaxially oriented laminated polyester film produced in a manner similar to the Example 24 and a film roll of a biaxially oriented laminated polyester film having a surface R laminated with a release layer A and the corona-treated surface Y was obtained. The obtained film was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 26

(An example to use a fluororesin layer as the release layer)

A film roll of a biaxially oriented laminated polyester film having a surface of the laminated release layer B and a surface Y without laminated layer was produced in a manner similar to the Example 1 except for coating of a 15% aqueous solution of Surflon S-112 (product of Asahi Glass Co., Ltd.) for forming the release layer B by a roll coater on one surface (surface X) of a longitudinally drawn film produced by a method similar to the Example 24 in an amount to get a layer thickness of 0.05 μm after the drying and lateral drawing procedures. The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 27

(An example to use an olefin resin layer as the release layer)

A biaxially oriented polyester film having a thickness of 20 μm and no release layers on both sides was produced by a method similar to the Example 24 except for no coating to a longitudinally drawn film. The coating liquid of the release agent having a solid concentration of 1% and produced by dissolving an alkyl-modified polyethyleneimine (PR-10, product of Nippon Shokubai Co., Ltd.) in a methyl ethyl ketone/toluene mixed solvent was coated in a manner similar to the Example 2 of the Japanese Patent 2,882,953 as a release layer C to the surface X of the polyester film in an amount of 10 g/m$^2$ and dried. The produced film was wound in the form of a roll to obtain a film roll of a biaxially oriented laminated polyester film having a surface R of the laminated release layer C having a coating film thickness of 0.1 μm and a surface Y with no laminated layers.

The obtained roll of the laminated polyester film was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 28

(An example to apply a polyvinyl carbamate layer as the release layer)

A film roll of a biaxially oriented laminated polyester film having a surface R of the laminated release layer D and a surface Y with no laminated layers was produced by a method similar to the Example 1 except for coating of 5% aqueous solution of Peeloil 406 (product of Ipposha Oil Ind. Co., Ltd.) as the release layer D to a surface (surface X) of a longitudinally drawn film obtained by a method similar to the Example 24 by a roll coater to get a release layer having a thickness of 0.05 μm after the drying and lateral drawing procedures.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 29

(An example to apply a wax layer as the release layer)

A film roll of a biaxially oriented laminated polyester film having a surface R of the laminated release layer E and a surface Y with no laminated layers was produced by a method similar to the Example 24 except for coating of 10% aqueous solution of EV-4 (219 parts by weight) and Himicron G-270 (137 parts by weight) (products of Chukyo Yushi. Co., Ltd.) as the release layer E to a surface (surface X) of a longitudinally drawn film obtained by a method similar to the Example 24 by a roll coater to get a release layer having a thickness of 0.05 μm after the drying and lateral drawing procedures.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 30

(An example to apply an olefin resin layer as the release layer by extrusion lamination)

A medium-density polyethylene was coated by extrusion lamination in a manner similar to the Example 1 of the Japanese Patent 2,882,953 as a release layer F to the surface Y of a biaxially oriented polyester film obtained by a method similar to the Example 27 and with no laminated layers on both surfaces to a thickness of 15 $\mu$m to obtain a film roll of a biaxially oriented laminated polyester film having a surface R laminated with the release layer F and a surface Y free from laminated layers.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Example 31

A film roll of a biaxially oriented polyester film of 20 $\mu$m thick having a surface R laminated with a release layer A and a surface Y with no laminated layers was produced by a method similar to the Example 24 except for the addition of antimony trioxide as a catalyst in an amount shown in the Table 5.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Comparative Example 16

A film roll of a biaxially oriented laminated polyester film having a surface R laminated with a release layer A of 0.1 $\mu$m thickness and a surface Y of the laminated release layer C was produced by coating a release agent liquid having a solid concentration of 1% and produced by dissolving an alkyl-modified polyethyleneimine (PR-10, product of Nippon Shokubai Co., Ltd.) in a methyl ethyl ketone/toluene mixed solvent in a manner similar to the Example 27 as a release layer C to the surface Y of a biaxially oriented polyester film produced by a method similar to the Example 1 and having a surface R of the laminated release layer A and a surface Y with no laminated layers in an amount of 10 g/m$^2$ and drying the coating liquid.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Comparative Example 17

A film roll of a biaxially oriented polyester film having a thickness of 20 $\mu$m and with no laminated layers on both surfaces was produced in a manner similar to the Example 24 except for the omission of coating of a liquid to a longitudinally drawn film. The film roll of the polyester film was kept under normal temperature and humidity condition for 1 week, a photoresist layer was laminated to a surface of the film, a printed circuit was formed on the surface and the characteristics of the photoresist film and the unwindability of the roll were evaluated. The results and the characteristics of the plain film are shown in the Table 5.

Comparative Example 18

A film roll of a biaxially oriented laminated polyester film of 20 $\mu$m thick having a surface R of the laminated release layer A and a surface Y with no laminated layer was produced in a manner similar to the Example 24 except for the addition of porous silica aggregate particles having an average particle diameter of 1.7 $\mu$m as a lubricant in an amount of 0.120% by weight based on the polymer.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Comparative Example 19

A film roll of a biaxially oriented laminated polyester film of 20 $\mu$m thick having a surface R of the laminated release layer A and a surface Y with no laminated layer was produced in a manner similar to the Example 24 except for the use of antimony trioxide as the polycondensation catalyst.

The obtained film roll was kept under normal temperature and humidity condition for 1 week, a photoresist layer was laminated to the surface Y of the film, a printed circuit was formed on the surface and the characteristics of the photoresist film and the unwindability of the roll were evaluated. The results and the characteristics of the plain film are shown in the Table 5.

Table 5

| | Film surface | | Water contact angle (°) | | Amount of Sb in polyester film ppm | Cataryst residue in polyester film ppm | Thick ness μm | UV trans mission | Haze | Property of photoresist film | | Unwind ability |
|---|---|---|---|---|---|---|---|---|---|---|---|---|
| | Surface R | Surface Y | $\theta_R$ | $\theta_Y$ | | | | | | Resolution | Circuit defect | |
| Example 24 | A | none | 110 | 79 | 0 | 100 | 20 | 86.5 | 2.8 | ◎ | ○ | ◎ |
| Example 25 | A | corona | 110 | 42 | 0 | 100 | 20 | 86.4 | 2.9 | ○ | ○ | ◎ |
| Example 26 | B | none | 123 | 80 | 0 | 100 | 20 | 86.1 | 2.8 | ○ | ○ | ◎ |
| Example 27 | C | none | 105 | 78 | 0 | 100 | 20 | 85.3 | 2.9 | ○ | ○ | ◎ |
| Example 28 | D | none | 109 | 78 | 0 | 100 | 20 | 84.6 | 2.9 | ○ | ○ | ◎ |
| Example 29 | E | none | 105 | 78 | 0 | 100 | 20 | 86.7 | 2.7 | ◎ | ○ | ◎ |
| Example 30 | F | none | 105 | 78 | 0 | 100 | 35 | 85.8 | 2.9 | ○ | ○ | ◎ |
| Example 31 | A | none | 110 | 79 | 10 | 140 | 20 | 86.2 | 3.0 | ○ | ○ | ◎ |
| Comparative Example 16 | A | C | 110 | 104 | 0 | 100 | 20 | 86.0 | 2.4 | ○ | ○ | 0 |
| Comparative Example 17 | none | none | 73 | 73 | 0 | 100 | 20 | 84.5 | 2.2 | ○ | ○ | × |
| Comparative Example 18 | A | none | 110 | 79 | 0 | 100 | 20 | 79.2 | 5.5 | × | × | ◎ |
| Comparative Example 19 | A | none | 110 | 79 | 16 | 200 | 20 | 79.0 | 2.5 | × | × | ◎ |

EP 1 459 886 B1

The abbreviations in the film surface column of the Table 5 mean the following film surface state.

A : Release layer A is laminated.
B : Release layer B is laminated.
C : Release layer C is laminated.
D : Release layer D is laminated.
E : Release layer E is laminated.
F : Release layer F is laminated.
corona : Corona discharge treatment is applied to the surface.
none: There is no lamination of release layer nor corona discharge treatment.

Effect of the Invention

The present invention provides an easily producible and handleable laminated film useful for a dry film photoresist having high resolution.

The laminated film prepared by the present invention has transparency and UV transmittance and good slipperiness and handleability and, accordingly, is suitable as a dry film photoresist coverless film having high resolution.

The dry film photoresist coverless film of the present invention is especially effective for the production of a printed circuit board.

**Claims**

1.  A laminated film for a dry film photoresist coverless film having a light transmittance of 80% or above at 365 nm wavelength and comprising a biaxially drawn polyester film and a release layer formed on one surface of the biaxially drawn polyester film,
    wherein the release layer has releasability to a photoresist layer composed of a photosetting resin,
    wherein the polyester comprised in the biaxially drawn polyester film is formed by a polycondensation reaction using a polycondensation catalyst, wherein the polycondensation catalyst is a germanium compound,
    wherein the amount of polycondensation metal catalyst residue in the polyester is less than 150 ppm,
    and wherein the polyester contains 0.01 to 0.1 wt% of porous silica particles having a pore volume of 0.5 to 2.0 ml/g and an average particle diameter of 0.1 to 5 $\mu$m.

2.  A laminated film described in the Claim 1 wherein said porous silica particle is an aggregate of primary particles having an average particle diameter of 0.01 to 0.1 $\mu$m.

3.  A laminated film described in the Claim 2 wherein the number of coarse aggregated particles of the porous silica particles having a size of 50 $\mu$m or larger is 10 or less per 1 m$^2$ of the film.

4.  A laminated film described in the Claim 1 wherein the content of antimony element is 15 mmol% or below based on the total dicarboxylic acid component of the polyester.

5.  A laminated film described in the Claim 1 wherein the polyester has an intrinsic viscosity of 0.52 to 1.50 dl/g.

6.  A laminated film described in the Claim 1 wherein the release layer contains at least one kind of material selected from silicone resin, fluororesin, olefin resin, wax, polyvinyl carbamate and chromium complex.

7.  A laminated film described in the Claim 1 wherein the contact angle of the biaxially drawn polyester film surface Y with water and the contact angle of the release layer surface R with water satisfy the following formulas (2), (4) and (5) at the same time.

$$20° \leq \theta Y \leq 90° \qquad (2)$$

$$60° \leq \theta R \leq 150° \qquad (4)$$

$$10° \leq \theta R - \theta Y \leq 130° \qquad (5)$$

(in the formulas (2), (4) and (5), $\theta Y$ is the contact angle of the polyester film surface with water and $\theta R$ is the contact angle of the release layer surface with water.)

8. A laminated film described in the Claim 1 wherein the center line average height (Ra) of at least one of the film surfaces is 0.005 $\mu$m or over.

9. A laminated film described in the Claim 1 wherein the film has a thickness of 2 to 200 $\mu$m.

10. A laminated film described in the Claim 1 wherein the film has a haze value of 5% or less.

11. A dry film photoresist coverless film having a photoresist layer on at least one surface of a laminated film described in the Claim 1.


**Patentansprüche**

1. Laminatfolie für eine abdeckungsfreie Trockenphotoresistfolie, die eine Lichtdurchlässigkeit von 80% oder mehr bei einer Wellenlänge von 365 nm aufweist und eine biaxial verstreckte Polyesterfolie und eine auf der Oberfläche der biaxial verstreckten Polyesterfolie ausgebildete Ablöseschicht umfasst,
wobei die Ablöseschicht Ablösbarkeit gegenüber einer aus einem lichthärtenden Harz bestehenden Photoresistschicht aufweist,
wobei der in der biaxial verstreckten Polyesterfolie enthaltene Polyester durch eine Polykondensationsreaktion unter Verwendung eines Polykondensationskatalysators gebildet wird, wobei es sich bei dem Polykondensationskatalysator um eine Germaniumverbindung handelt,
wobei die Menge an Polykondensationsmetallkatalysatorrückstand in dem Polyester weniger als 150 ppm beträgt und wobei der Polyester 0,01 bis 0,1 Gew.-% poröse Siliciumdioxidteilchen mit einem Porenvolumen von 0,5 bis 2,0 ml/g und einem mittleren Teilchendurchmesser von 0,1 bis 5 $\mu$m enthält.

2. Laminatfolie gemäß Anspruch 1, wobei es sich bei dem porösen Siliciumdioxidteilchen um ein Aggregat von Primärteilchen mit einem mittleren Teilchendurchmesser von 0,01 bis 0,1 $\mu$m handelt.

3. Laminatfolie gemäß Anspruch 2, wobei die Zahl grober aggregierter Teilchen der porösen Siliciumdioxidteilchen mit einer Größe von 50 $\mu$m oder mehr 10 oder weniger pro 1 m² der Folie beträgt.

4. Laminatfolie gemäß Anspruch 1, wobei der Gehalt an Antimon-Element 15 mmol-% oder weniger, bezogen auf die gesamte Dicarbonsäurekomponente des Polyesters, beträgt.

5. Laminatfolie gemäß Anspruch 1, wobei der Polyester eine intrinsische Viskosität von 0,52 bis 1,50 dl/g aufweist.

6. Laminatfolie gemäß Anspruch 1, wobei die Ablöseschicht mindestens eine Art von Material, ausgewählt aus Silikonharz, Flurharz, Olefinharz, Wachs, Polyvinylcarbamat und Chromkomplex, enthält.

7. Laminatfolie gemäß Anspruch 1, wobei der Kontaktwinkel der Oberfläche Y der biaxial verstreckten Polyesterfolie mit Wasser und der Kontaktwinkel der Ablöseschichtoberfläche R mit Wasser gleichzeitig die folgenden Formeln (2), (4) und (5) erfüllen:

$$20° \leq \theta Y \leq 90° \qquad (2)$$

$$60° \leq \theta R \leq 150° \qquad (4)$$

$$10° \leq \theta R - \theta Y \leq 130° \qquad (5)$$

(in den Formeln (2), (4) und (5) ist θ Y der Kontaktwinkel der Polyesterfolienoberfläche mit Wasser und θ R der Kontaktwinkel der Ablöseschichtoberfläche mit Wasser.)

8. Laminatfolie gemäß Anspruch 1, wobei der Mittenrauwert (Ra) mindestens einer der Folienoberflächen 0,05 μm oder mehr beträgt.

9. Laminatfolie gemäß Anspruch 1, wobei die Folie eine Dicke von 2 bis 200 μm aufweist.

10. Laminatfolie gemäß Anspruch 1, wobei die Folie einen Trübungswert von 5% oder weniger aufweist.

11. Abdeckungslose Trockenphotoresistfolie mit einer Photoresistschicht auf mindestens einer Oberfläche einer Laminatfolie gemäß Anspruch 1.

**Revendications**

1. Film stratifié pour un film photosensible sec sans revêtement ayant un facteur de transmission de la lumière de 80 % ou plus à une longueur d'onde de 365 nm et comprenant un film de polyester étiré biaxialement et une couche détachable formée sur une surface du film de polyester étiré biaxialement,

   dans lequel la couche détachable est capable de se détacher d'une couche photosensible constituée d'une résine photodurcissable,

   dans lequel le polyester présent dans le film de polyester étiré biaxialement est formé par une réaction de polycondensation utilisant un catalyseur de polycondensation, le catalyseur de polycondensation étant un composé de germanium,

   dans lequel la quantité de résidu de catalyseur de polycondensation métallique présente dans le polyester est inférieure à 150 ppm,

   et dans lequel le polyester contient de 0,01 à 0,1

   % en poids de particules de silice poreuse ayant un volume de pores de 0,5 à 2,0 ml/g et un diamètre de particule moyen de 0,1 à 5 μm.

2. Film stratifié selon la revendication 1, dans lequel ladite particule de silice poreuse est un agrégat de particules primaires ayant un diamètre de particule moyen de 0,01 à 0,1 μm.

3. Film stratifié selon la revendication 2, dans lequel le nombre de particules agrégées grossières des particules de silice poreuse ayant une taille de 50 μm ou plus est de 10 ou moins par 1 m$^2$ du film.

4. Film stratifié selon la revendication 1, dans lequel la teneur en élément antimoine est de 15 mmol % ou moins relativement au constituant acide dicarboxylique total du polyester.

5. Film stratifié selon la revendication 1, dans lequel le polyester a une viscosité intrinsèque de 0,52 à 1,50 dl/g.

6. Film stratifié selon la revendication 1, dans lequel la couche détachable contient au moins un type de matériau sélectionné parmi une résine de silicone, une résine fluorée, une résine oléfinique, une cire, un carbamate de polyvinyle et un complexe de chrome.

7. Film stratifié selon la revendication 1, dans lequel l'angle de contact de la surface du film de polyester étiré biaxialement Y avec l'eau et l'angle de contact de la surface de la couche détachable R avec l'eau satisfont simultanément les formules suivantes (2), (4) et (5) :

$$20° \leq \theta Y \leq 90° \qquad (2)$$

$$60° \leq \theta R \leq 150° \qquad (4)$$

$$10° \leq \theta R - \theta Y \leq 130° \qquad (5)$$

(dans les formules (2), (4) et (5), $\theta Y$ est l'angle de contact de la surface du film de polyester avec l'eau et $\theta R$ est l'angle de contact de la surface de la couche détachable avec l'eau).

8. Film stratifié selon la revendication 1, dans lequel la hauteur moyenne (Ra) de la ligne médiane d'au moins une des surfaces du film est de 0,005 $\mu$m ou plus.

9. Film stratifié selon la revendication 1, le film ayant une épaisseur de 2 à 200 $\mu$m.

10. Film stratifié selon la revendication 1, le film ayant une valeur de voile de 5 % ou moins.

11. Film photosensible sec sans revêtement comportant une couche photosensible sur au moins une surface d'un film stratifié selon la revendication 1.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0905564 A2
- JP 2882953 B

- JP 7333853 A

**Non-patent literature cited in the description**

- Particle Size Measuring Technique. Nikkan Kogyo Shimbun, Ltd, 1975, 242-247